# EUROPÄISCHE PATENTSCHRIFT

(11) **EP 0 436 531 B1**
(45) Veröffentlichungstag und Bekanntmachung des Hinweises auf die Patenterteilung: **24.03.1993**
(21) Anmeldenummer: 89900193.7
(22) Anmeldetag: 21.12.1988
(51) Int. Cl.: H05K 5/00, H05K 7/18

(54) **SCHWENKBARE VORRICHTUNG ZUR AUFNAHME VON BAUGRUPPEN**
SWIVELLING DEVICE FOR SUPPORTING COMPONENTS
DISPOSITIF PIVOTANT POUR RECEVOIR DES ENSEMBLES DE COMPOSANTS

(30) Priorität: 28.09.1988 DE 8812275 U
(43) Veröffentlichungstag der Anmeldung: 17.07.1991
(73) Patentinhaber: SIEMENS AKTIENGESELLSCHAFT, 80333 München (DE)
(72) Erfinder: GEBHARD, Bruno, D-8550 Forchheim (DE); HECHT, Franz, D-8520 Erlangen (DE)
(86) Internationale Anmeldenummer: DE8800773
(87) Internationale Veröffentlichungsnummer: WO9003720

(56) Entgegenhaltungen:
- FR-E- 74 758
- US-A- 2 869 958
- US-A- 3 641 395
- US-A- 4 523 254

## Beschreibung

Die Erfindung bezieht sich auf eine schwenkbare Vorrichtung zur Aufnahme mehrerer parallel zueinander angeordneter Baugruppen unterschiedlicher Baugruppentiefe.

Aus dem Firmenprospekt mit dem Titel "3 ~ SIMOREG-K-Geräte in Hybridtechnik - Drehzahlveränderbare Gleichstromantriebe" der Firma Siemens AG ist es bekannt, daß Baugruppen mit aus einer Gerätewand geformten Laschen lösbar verbunden sind. Dabei sind die Baugruppen übereinander angeordnet. Diese Anordnung von Baugruppen ist auch unter dem Ausdruck "Sandwich-Anordnung" bekannt. Diese Sandwich-Anordnung ermöglicht eine sehr kompakte platzsparende Bauweise.

Aus dem Firmenprospekt mit dem Titel "SIMOREG K Stromrichtergeräte für Einphasenanschluß - Drehzahlveränderbare Gleichstromantriebe" der Firma Siemens AG, Ausgabe Dezember 1985, Bestell-Nr. A19100-E319-A268, ist es bekannt, daß mehrere Baugruppen mittels Stehbolzen zu Sandwich-Anordnungen zusammengesetzt werden. Diese Sandwich-Anordnungen von Baugruppen können mittels weiterer Stehbolzen flach in einem Gehäuse oder in eiem 19-Zoll-Einbaurahmen bei geringer Einbaufläche eingebaut werden. Ein weiterer Vorteil des 19-Zoll-Einbaurahmens ist es, daß mehrere Sandwich-Anordnungen von Baugruppen nebeneinander im Einbaurahmen angeordnet sein können.

Durch diese Sandwich-Anordnung von Baugruppen ist der Zugang zu einer speziellen Baugruppe erschwert, da in Abhängigkelt des Stapelplatzes dieser Baugruppe alle Baugruppen mit einer kleineren Platznummer, unter der Voraussetzung, daß die zugänglichste Baugruppe die Platznummer 1 hat, ausgebaut werden müssen. Dadurch erhöht sich der Montageaufwand erheblich.

Aus dem Firmenprospekt mit dem Titel "SIMOREG K Stromrichtergeräte für Drehstromanschluß und Vierquadrantenbetrieb - Drehzahlveränderbare Gleichstromantriebe" der Firma Siemens AG, Ausgabe September 1987, Bestell-Nr. A19100-E319-A197, ist bekannt, daß Baugruppen jeweils mit einer schwenkbaren Aufnahme lösbar verbunden ist, wobei jede Baugruppe mittels eines Metallbügels in einem Gehäuse an den der schwenkbaren Aufnahme gegenüberliegenden Ecken verankert ist. Bei dieser Anordnung von Baugruppen in einem Gehäuse müssen alle Baugruppen das gleiche Format haben, wobei die Anschlußelemente (Steckklemmen, Bussteckverbinder) beim Herausschwenken gezogen sein müssen, oder eine aufwendige Leitungsführung notwendig ist. Somit ist diese Anordnung von Baugruppen nicht vielseitig einsetzbar und durch den zusätzlichen Klappmechanismus kompliziert und aufwendig in der Montage.

Der Erfindung liegt nun die Aufgabe zugrunde, eine Anordnung von Baugruppen unterschiedlicher Baugruppentiefe anzugeben, die platzsparend, vielseitig anwendbar und service- und bedienungsfreundlich ist.

Diese Aufgabe wird erfindungsgemäß dadurch gelöst, daß die schwenkbare Vorrichtung zur Aufnahme mehrerer parallel zueinander angeordneter Baugruppen unterschiedlicher Baugruppentiefe aus zwei Seitenteilen und einer verbindenden mit einem Befestigungsmittel versehenen Rückwand besteht, wobei jedes Seitenteil mit einer U-förmigen Aufnahme für einen Bolzen, mit einer dieser Aufnahme gegenüberliegenden Handhabe, mit einer radial zur Aufnahme auf einer Außenfläche angeordneten Führung, die mit einer zur Aufnahme hin geöffneten Einführungsöffnung versehen ist, und mit Führungsschienen versehen ist, die auf einer Innenfläche angeordnet sind, wobei jeder Führungsschiene am Ende ein Anschlag zugeordnet ist.

Mit dieser schwenkbaren Vorrichtung können Baugruppen unterschiedlicher Baugruppentiefe zu einem Baugruppen-Stapel zusammengefaßt werden. Da jede Baugruppe in Führungsschienen geführt ist, benötigt man dafür keine mechanischen Verbindungselemente wie Stehbolzen. Außerdem kann im Falle eines Defektes einer Baugruppe diese schnell ausgetauscht werden, ohne dabei erst andere Baugruppen zu entfernen. Dabei wird diese auch als Baugruppenträger bezeichnete schwenkbare Vorrichtung aus einem Gehäuse herausgeschwenkt. In diesem herausgeschwenkten Zustand, wobei der Wert des Schwenkwinkels beispielsweise 45° beträgt, ist jede Baugruppe frei zugänglich. Zum Austauschen einer defekten Baugruppe müssen nur noch die Steckverbinder gezogen werden.

In einer weiteren Ausführungsform der schwenkbaren Vorrichtung zur Aufnahme mehrerer parallel zueinander angeordneter Baugruppen ist die Rückwand aus Metall. Dadurch sind die Baugruppen der Vorrichtung elektromagnetisch gegenüber Leistungsbauelementen mit einer zugehörigen Ansteuerbaugruppe, die in einem Zwischenraum, bestehend aus einer Gehäuserückwand und der Rückwand der schwenkbaren Vorrichtung, angeordnet sind, abgeschirmt. Somit sind für die auf den Baugruppen der Vorrichtung angeordneten Bauelemente alle EGB-Maßnahmen eingehalten.

In einer vereinfachten Ausführungsform der schwenkbaren Vorrichtung, bei der die Baugruppen stufenförmig angeordnet sind, ist als Rückwand eine Baugruppe vorgesehen. Außerdem sind die Baugruppen jeweils mit einem lösbaren Verbindungselement mit dem entsprechenden Anschlag lösbar verbunden. Durch die lösbare Verbindung zwischen Baugruppe und Vorrichtung wird die Stabilität dieser Vorrichtung erhöht. Bei dieser Ausführungsform sind die beiden Handhaben der Seitenteile mit einem Rastmittel versehen, damit, nachdem die Vorrichtung in seine Betriebsstellung geschwenkt ist, diese Vorrichtung auch in dieser Stellung gehalten werden kann.

Um das Gewicht dieser schwenkbaren Vorrichtung möglichst gering zu halten, sind die Seitenteile aus Kunststoff. Dabei kann als Seitenteil eine Kunststoffplatte vorgesehen sein, in der bzw. auf der auf der einen Seite die Führungsschienen und auf der anderen Seite die radial zur U-förmigen Aufnahme angeordnete Führung eingearbeitet bzw. angebracht sind. Damit das Gewicht bei gleicher Stabilität der Seitenteile weiter reduziert werden kann, wobei die Herstellung einfach und kostengünstig sein soll, ist jeweils das Seitenteil als Spritzteil ausgebildet, wobei jeweils zusätzliche Versteifungsrippen vorgesehen sind.

Zur weiteren Erläuterung der Erfindung wird auf die Zeichnung Bezug genommen, in der Ausführungsbeispiele der schwenkbaren Vorrichtung nach der Erfindung schematisch veranschaulicht sind.
- FIG 1: zeigt eine Seitenansicht einer besonders einfachen Ausführungsform einer erfindungsgemäßen schwenkbaren Vorrichtung zur Aufnahme mehrerer Baugruppen in einem Gehäuse, in
- FIG 2: ist eine Frontansicht der schwenkbaren Vorrichtung in einem Gehäuse nach FIG 1 dargestellt und
- FIG 3: veranschaulicht eine besonders kostengünstige und steife Vorrichtung zur Aufnahme von mehreren Baugruppen.

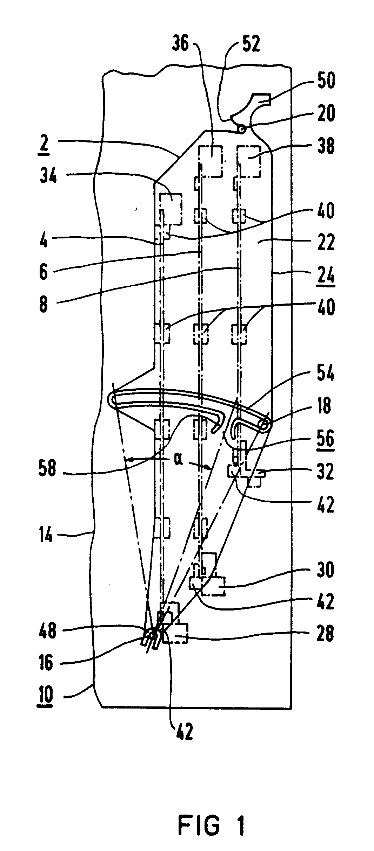

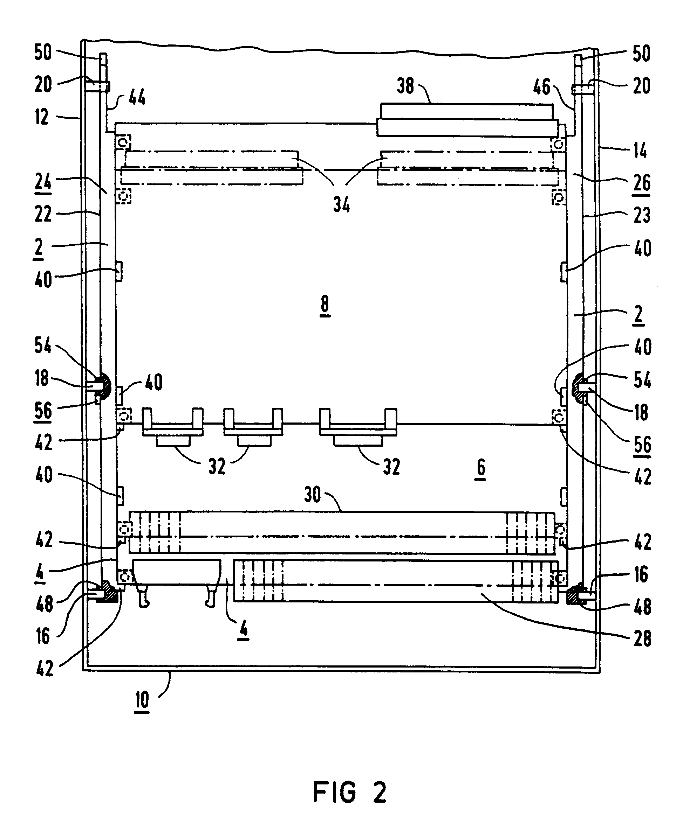

In FIG 1 ist eine schwenkbare Vorrichtung 2 zur Aufnahme mehrerer Baugruppen 4, 6 und 8 in einem Gehäsue 10 eines elektrischen Gerätes, beisplelsweise eines Stromrichtergerätes für drehzahlveränderbare Gleich- bzw. Wechselstromantriebe, dargestellt. Diese schwenkbare Vorrichtung 2 ist zwischen zwei Gehäuseseitenwänden 12 und 14 aufgehängt. Dafür ist jede Gehäuseseitenwand 12 und 14 mit drei Bolzen 16, 18 und 20 versehen. Von den beiden Gehäuseseitenwänden 12 und 14 ist nur die Gehäuseseitenwand 14 zu sehen, da diese dargestellte Seitenansicht eine Seitenansicht von links ist, wobei die linke Gehäuseseitenwand 12 weggebrochen ist, jedoch ihre Bolzen 16, 18 und 20 zum besseren Verständnis dargestellt sind. Dadurch ist der Blick auf die Innenseite der Gehäuseseitenwand 14 und auf die Außenfläche 22 des linken Seitenteils 24 der schwenkbaren Vorrichtung 2 frei. Das rechte Seitenteil 26 dieser Vorrichtung 2 wird bei dieser Ansicht durch das Seitenteil 24 verdeckt. Eine Frontansicht der schwenkbaren Vorrichtung 2 nach FIG 1 ist in der FIG 2 dargestellt, die die Gehäuseseitenwand 12 und das Seitenteil 26 zeigt. Da durch die Darstellung der FIG 1 die Einzelheiten der Vorrichtung 2 verdeckt sind, wird bei der weiteren Beschreibung dieser Vorrichtung 2 Bezug genommen auf die FIG 1 und die FIG 2.

Die Baugruppen 4, 6 und 8, die jeweils mit einem Steckverbinder 28, 30 und 32 und einem Bussteckverbinder 34, 36 und 38 versehen sind, sind stufenförmig in Führungsschienen 40 angeordnet. Dabei sind die Führungsschienen 40 bei dieser einfachen Ausführungsform jeweils nur noch in Flucht angeordnete Teilstücke einer Führungsschiene 40 hintereinander angeordnet, die auf der Innenseite 44 bzw. 46 des Seitenteils 24 bzw. 26 angeordnet sind. Damit die einzelnen Baugruppen 4, 6 und 8 nicht durchrutschen können, ist jeweils am Ende einer Führungsschiene 40 ein Anschlag 42 angebracht, auf dem sich die Baugruppe 4 bzw. 6 bzw 8 abstützen kann. Durch die Anordnung der Führungsschiene 40 und der Anschläge 42 sind die Baugruppen 4, 6 und 8 stufenförmig angeordnet. Dadurch ist es auch möglich, die Baugruppen 4, 6 und 8 unabhängig voneinander jeweils mit den Anschlägen 42 lösbar zu verbinden, damit der Wert der Steifigkeit der Vorrichtung 2 möglichst hoch ist. Außerdem hat die Baugruppe 8 eine geringere Baugruppentiefe als die Baugruppe 4 und 6. Da in FIG 1 eine besonders einfache Ausführungsform der schwenkbaren Vorrichtung 2 dargestellt ist, bildet die Baugruppe 4 gleichzeitig eine Rückwand der Vorrichtung 2.

Das Seitenteil 24 ist außerdem mit einer U-förmigen Aufnahme 48 und mit einer Handhabe 50 versehen. Dabei umgreift die U-förmige Aufnahme den Bolzen 16, der als Drehachse dient. Die Handhabe 50, die gegenüber der U-förmigen Aufnahme 28 am Seitenteil 24 angeordnet ist, weist auch noch ein Rastmittel 52 auf. Als Rastmittel 52 ist eine weitere U-förmige Aufnahme vorgesehen, deren Öffnung sich verjüngt. Diese U-förmige Aufnahem des Rastmittels 52 ist derartig angeordnet, daß deren Öffnung auf die Einschubebene der Baugruppen 4, 6 und 8 gerichtet ist. In der Betriebsstellung, gemäß der Darstellung der FIG 1, umschließt die U-förmige Aufnahme des Rastmittels 52 den Bolzen 20. Außerdem ist auf der Außenfläche 22 des Seitenteils 24 eine Führung 54 angebracht, die radial zur U-förmigen Aufnahme 48 angeordnet ist. In dieser Führung 54 gleitet der Bolzen 18 von der dargestellten Betriebsstellung in die Prüfstellung, die eingenommen wird, wenn der Bolzen 18 sich am anderen Ende der Führung 54 in der nicht dargestellten Stellung befindet. In unmittelbarer Nähe der Betriebsstellung ist die Führung 54 mit einer Einführungsöffnung 56 versehen, die zusätzlich mit einer Fangvorrichtung 58 versehen ist. Die Öffnung dieser Fangvorrichtung 58 ist in Richtung der U-förmigen Aufnahme 48 gerichtet. Durch diese Anordnung der Einführungsöffnung 56 wird die schwenkbare Vorrichtung 2 annähernd in der Stellung für den Betrieb in das Gehäuse 10 eines Gerätes eingeführt und dann in die Betriebsstellung bzw. Prüfstellung geschwenkt. Diese beiden Stellungen schließen einen Schwenkwinkel α von 45° ein.

Durch diese Ausgestaltung der erfindungsgemäßen Vorrichtung 2 erhält man einen schwenkbaren Baugruppenträger, der mehrere Baugruppen 4, 6 und 8 unterschiedlicher Baugruppentiefe aufnehmen kann. Dieser schwenkbare Baugruppenträger benötigt nur eine geringe Schrank- bzw. Gehäusetiefe, wie bei einer Sandwich-Aordnung mehrerer Baugruppen 4, 6 und 8. Dabei sind die Baugruppen 4, 6 und 8 einzeln austauschbar und platzsparend in einem Gehäuse angeordnet, deren Handhabung service- und bedienungsfreundlich sind.

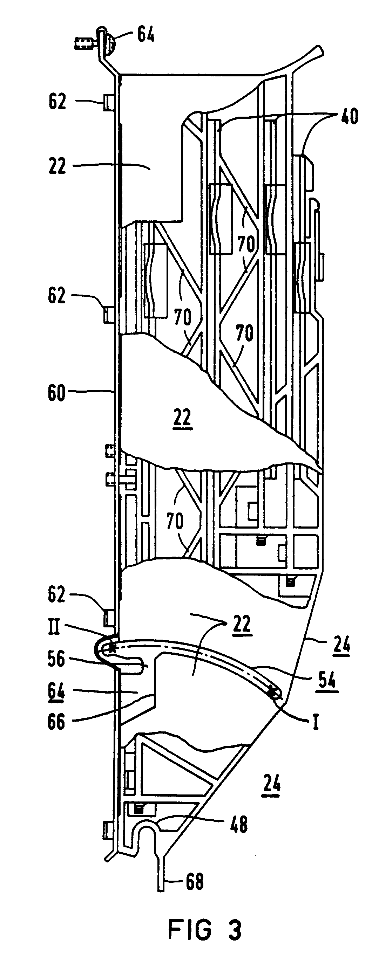

Die FIG 3 zeigt eine besonders kostengünstige und steife Vorrichtung 2 zur Aufnahme von mehreren Baugruppen 4, 6 und 8. Alle Bauelemente dieser Ausführungsform, die identisch mit den Bauelementen der Ausführungsform nach FIG 1 bzw. FIG 2 sind, erhalten die gleichen Bezugszeichen. Gegenüber der Ausführungsform nach FIG 1 bzw. FIG 2 enthält die Vorrichtung 2 eine Rückwand 60, die mittels Einpreßbolzen 62 mit den Seitenteilen 24 und 26 verbunden ist. Die Rückwand 60 ist aus Metall und hat ein zentral angeordnetes Befestigungsmittel 64. Die metallische Rückwand 60 sorgt für eine elektromagnetische Abschirmung der Baugruppen dieser Vorrichtung 2 gegenüber Bauelementen, die im Gehäuse 10 zwischen einer Gehäuserückwand und dieser Rückwand 60 angeordnet sein können.

Außerdem ist bei dieser Ausführungsform der Vorrichtung 2 die Einführungsöffnung 56 der Führung 54 in Richtung der Prüfstellung verschoben worden, die durch ein mit II gekennzeichnetes Kreuz bezeichnet ist, wogegen die Betriebsstellung durch ein mit I gekennzeichnetes Kreuz markiert ist. Durch die Verlegung der Einführungsöffnung 56 der Führung 54 ist auch die Fangvorrichtung, die hier mit 64 bezeichnet ist, abgeändert. Diese Fangvorrichtung 64 hat eine abgeknickte Führung 66, auf der der Bolzen 18 in die Führung 54 gleitet, wenn die Vorrichtung 2 in ein Gehäuse 10 eines Gerätes eingesetzt wird. Um das Einsetzen noch zu vereinfachen, ist die U-förmige Aufnahme 48 mit einer Verlängerungsschiene 68 versehen. Beim Einsetzen dieser Vorrichtung 2 stützen sich der Bolzen 16 am unteren Ende der Verlängerungsschiene 68 und der Bolzen 18 am Anfang der abgeknickten Führung 66 ab. Nun braucht man die Vorrichtung 2 nur noch ein wenig absenken bei gleichzeitigem Andrücken an die Bolzen 16 und 18, wodurch der Bolzen 16 von der U-förmigen Aufnahme 48 umgriffen wird und der Bolzen 18 in die Führung 54 gelangt. Dann braucht man diese Vorrichtung 2 nur noch in die Prüfstellung bzw. Betriebsstellung zu schwenken.

Außerdem sind bei dieser Ausführungsform Führungsschienen 40 vorgesehen, deren Nuten Leiterplatten mit unterschiedlichen Dicken aufnehmen können. Derartige Führungsschiene sind aus der DE-OS 36 24 839 bekannt. Außerdem sind bei dieser Ausführungsform des Seitenteils 24 bzw. 26 vier Führungsschienen 40 vorgesehen. Zwischen den einzelnen Führungsschienen 40 sind zusätzliche Versteifungsrippen 70 angeordnet, damit das als Spritzgußteil hergestellte Seitenteil 24 bzw. 26 eine verbesserte Steifigkeit erhält. Überdeckt wird dieses Gerippe des Seitenteils 24 bzw. 26 von einer dünnen Außenfläche 22 bzw. 23, die zur besseren Darstellung des Seitenteils 24 bzw. 26 nur bereichsweise dargestellt ist.

Mit dieser Ausführungsform des Seitenteils 24 bzw. 26 erhält man eine schwenkbare Vorrichtung 2, die als Baugruppenträger für mehrere Baugruppen 4, 6 und 8 unterschiedlicher Baugruppentiefe dient, wobei der Platzbedarf in einem Gehäuse 10 für eine Sandwich-Anordnung von Baugruppen nicht übersteigt, jedoch die Handhabung der Baugruppen sehr viel service- und bedienungsfreundlicher ist bei erhöhter Steifigkeit der Vorrichtung 2.

## Patentansprüche

1. Schwenkbare Vorrichtung (2) zur Aufnahme mehrerer parallel zueinander angeordneter Baugruppen (4, 6, 8) unterschiedlicher Baugruppentiefe, bestehend aus zwei Seitenteilen (24, 26) und einer verbindenden mit einem Befestigungsmittel (64) versehenen Rückwand (60), wobei jedes Seitenteil (24, 26) mit einer U-förmigen Aufnahme (48) für einen Bolzen (16), mit einer dieser Aufnahme (48) gegenüberliegenden Handhabe (50), mit einer radial zur Aufnahme (48) auf einer Außenfläche (22, 23) angeordneten Führung (54), die mit einer zur Aufnahme (48) hin geöffneten Einführungsöffnung (56) versehen ist, und mit Führungsschienen (40) versehen ist, die auf einer Innenfläche (44, 46) angeordnet sind, wobei jeder Führungsschiene (40) am Ende ein Anschlag (42) zugeordnet ist.

2. Schwenkbare Vorrichtung (2) nach Anspruch 1, **dadurch gekennzeichnet,** daß die Rückwand (60) aus Metall ist.

3. Schwenkbare Vorrichtung (2) nach Anspruch 1, **dadurch gekennzeichnet,** daß als Rückwand (60) eine Baugruppe (4) vorgesehen ist.

4. Schwenkbare Vorrichtung (2) nach den Ansprüchen 1 und 3, **dadurch gekennzeichnet,** daß die Handhabe (50) mit einem Rastmittel (52) versehen ist.

5. Schwenkbare Vorrichtung (2) mit stufenförmigen angeordneten Baugruppen (4, 6, 8) nach Anspruch 1, **dadurch gekennzeichnet,** daß jede Baugrupe (4, 6, 8) im eingeschobenen Zustand mit dem zugehörigen Anschlag (42) lösbar verbindbar ist.

6. Schwenkbare Vorrichtung (2) nach Anspruch 1, **dadurch gekennzeichnet,** daß die Seitenteile (24, 26) aus Kunststoff sind.

7. Schwenkbare Vorrichtung (2) nach Anspruch 1 oder 6, **dadurch gekennzeichnet,** daß die mit den Führungsschienen (40) versehenen Innenflächen (44, 46) jeweils mit zusätzlichen Versteifungsrippen (70) versehen sind.

## Claims

1. Swivelling device (2) for holding several modules (4, 6, 8) arranged parallel to each other and of different module depths, comprising two side parts (24, 26) and a connecting rear wall (60) provided with an attachment means (64), each side part (24, 26) being provided with a U-shaped holding fixture (48) for a pin (16), a handle (50) opposite this holding fixture (48), a guide (54) arranged radially to the holding fixture (48) on an outer surface (22, 23), this guide being provided with an entry opening (56) which opens towards the holding fixture (48), and guide rails (40) which are arranged on an inner surface (44, 46), with a limit stop (42) being assigned to the end of each guide rail (40).

2. Swivelling device (2) according to claim 1, characterised in that the rear wall (60) is of metal.

3. Swivelling device (2) according to claim 1, characterised in that a module (4) is provided as the rear wall (60).

4. Swivelling device (2) according to claims 1 and 3, characterised in that the handle (50) is provided with a latching means (52).

5. Swivelling device (2) having modules (4, 6, 8) arranged in a stepped manner, according to claim 1, characterised in that each module (4, 6, 8) can be detachably connected in the inserted state to the associated limit stop (42).

6. Swivelling device (2) according to claim 1, characterised in that the side parts (24, 26) are of a plastics material.

7. Swivelling device (2) according to claim 1 or 6, characterised in that the inner surfaces (44, 46) provided with the guide rails (40) are respectively provided with additional stiffening ribs (70).

## Revendications

1. Dispositif pivotant (2) servant à recevoir plusieurs modules (4,6,8) qui sont disposés parallèlement entre eux et qui ont des profondeurs différentes, constitué par deux éléments latéraux (24,26) et une paroi arrière de liaison (60) pourvue d'un moyen de fixation (64), chaque élément latéral (24,26) étant pourvu d'un logement en forme de U (48) pour un boulon (16), une poignée (50) située à l'opposé de ce logement (48), un guide (54) disposé radialement par rapport au logement (48) sur une surface extérieure (22,23) et pourvu d'une ouverture d'introduction (56) qui s'ouvre en direction du logement (48), et des rails de guidage (40), qui sont disposés sur une surface intérieure (44,46), une butée (42) étant associée à chaque rail de guidage (42), au niveau de son extrémité.

2. Dispositif pivotant (2) suivant la revendication 1, caractérisé par le fait que la paroi arrière (60) est réalisée en un métal.

3. Dispositif pivotant suivant la revendication 1, caractérisé par le fait qu'il est prévu comme paroi arrière (60) un module (4).

4. Dispositif pivotant (2) suivant les revendications 2 et 3, caractérisé par le fait que la poignée (50) est équipée de moyens d'encliquetage (52).

5. Dispositif pivotant (2) comportant des modules (4,6,8) disposés de façon échelonnée suivant la revendication 1, caractérisé par le fait qu'à l'état inséré, chaque module (4,6,8) peut être raccordé de façon amovible à la butée associée (42).

6. Dispositif pivotant (2) suivant la revendication 1, caractérisé par le fait que les éléments latéraux (24,26) sont réalisés en matière plastique.

7. Dispositif pivotant (2) suivant la revendication 1 ou 6, caractérisé par le fait que les surfaces intérieures (44,46), pourvues des rails de guidage (40), sont pourvues respectivement de nervures supplémentaires de renforcement (70).
